# EUROPEAN PATENT APPLICATION

(11) **EP 1 677 345 A1**
(43) Date of publication of application: **05.07.2006**
(21) Application number: 04773800.0
(22) Date of filing: 13.10.2004
(51) Int. Cl.: H01L 21/60

(54) **BONDING WIRE AND INTEGRATED CIRCUIT DEVICE USING THE SAME**

(30) Priority: 20.10.2003 JP 2003358971; 20.10.2003 JP 2003359185; 20.10.2003 JP 2003359814; 03.12.2003 JP 2003404903
(71) Applicant: Sumitomo Electric Industries, Ltd., Osaka-shi, Osaka 541-0041 (JP)
(72) Inventor: KAIMORI, S., Osaka Works Sumitomo Elect. Ind.Ltd., Osaka-shi Osaka 5540024 (JP); NONAKA, Tsuyoshi, Sumitomo Electric Wintec, Inc., Kouka-shi Shiga5291811 (JP); IOKA, Masanori, Sumitomo Electric Wintec, Inc., Kouka-shi Shiga 5291811 (JP)
(74) Representative: Cross, Rupert Edward Blount
(86) International application number: PCT/JP2004/015448
(87) International publication number: WO 2005/038902

(57) **Abstract**

A bonding wire comprising a core and a coating layer formed on the core, wherein the coating layer is formed from a metal having a higher melting point than the core, and further has at least one of the following characteristics;
1. the wet contact angle with the coating layer when the core is melted is not smaller than 20 degrees;
2. when the bonding wire is hung down with its end touching a horizontal surface, and is cut at a point 15 cm above the end and thus let drop onto the horizontal surface, the curvature radius of the formed arc is 35 mm or larger;
3. the 0.2% yield strength is not smaller than 0.115 mN/µm² but not greater than 0.165 mN/µm²; or
4. the Vickers hardness of the coating layer is 300 or lower.

## Description

### [TECHNICAL FIELD]

The present invention relates to a bonding wire for connecting electrodes on an integrated circuit device (ICs, LSIS, transistors, and the like.) to conductive wires on a circuit wiring substrates (lead frames, ceramic substrates, printed circuit boards, and the like), and also relates to an integrated circuit device using such a bonding wire.

### [BACKGROUND ART]

A ball bonding method that uses bonding wires is employed as a method for connecting an integrated circuit device to a circuit wiring board.

The ball bonding method is a commonly practiced process in which the end of a bonding wire being guided by a movable capillary (hereinafter called the "bonding tool") is melted by an electric discharge between it and an electrode torch to form a ball on that end, after which the ball is pressed against a first bonding point to form a ball bond thereon, and then, while feeding out the wire, the bonding tool is moved to a second bonding point to form a connection in like manner (but this time a ball is not formed). After the connection is made, the bonding tool is lifted up, and the wire is pulled by clamps to cut off the wire.

If the first bonding point is on an electrode on an integrated circuit device and the second bonding point is on an electrode on a circuit wiring board, or if the first bonding point is on an electrode on a circuit wiring board and the second bonding point is on an electrode on an integrated circuit device, the electrode on the integrated circuit device and the electrode on the circuit wiring board are electrically connected.

So far, gold has been used as the material for bonding wires, but since gold is expensive, bonding wires made of inexpensive copper (copper bonding wires) have been developed; one such bonding wire is disclosed, for example, in Japanese Patent Publication No. 08-28382. However, copper bonding wires have the problems that the wire is not suitable for long-term storage because the wire surface easily oxidizes, and that oxidation proceeds due to heat conduction from the substrate during the bonding, resulting in a degradation of bonding quality.

Japanese Laid-open Patent Publication No. 62-97360 proposes a bonding wire that uses copper as the core material, with the core coated with a noble metal or a corrosion resistant metal, such as gold, silver, platinum, palladium, nickel, cobalt, chromium, or titanium. It is claimed that such a bonding wire is less expensive than gold bonding wire and yet is capable of forming good bonds free from surface oxidation.

The present inventors have found that the copper bonding wire coated with gold or the like has the problem that, when the diameter of the formed ball is small, the ball shape does not become a true spherical shape but becomes a spear-like shape, and also the problem that the reproducibility of the ball shape is unstable and the bond reliability decreases. To solve these problems, the present inventors have proposed a bonding wire characterized in that an oxidation resistant metal having a higher melting point than copper is used as the coating layer, and in that the elongation per unit cross sectional area is 0.021%/µm² or greater (WO 03/036710A1).

The present inventors have also proposed a copper bonding wire coated with palladium or the like, characterized in that a different metal layer is provided between the coating layer and the core for such purposes as preventing degradation of the plating solution when forming the coating layer by plating, and enhancing adhesion between the coating layer and the core (PCT/JP 03/03492).

Furthermore, the present inventors have also investigated ball shape reproducibility for bonding wires whose cores are formed from a material other than copper and coated with a metal different to that used as the core material. As a result, it has been found that, for such bonding wires also, when the melting point of the coating layer is lower than that of the core material, the ball is formed in a spear-like shape, and when the melting point of the coating layer is higher than that of the core material, a displacement can occur between the center of the wire and the center of the ball.

In the case of the copper bonding wire, the ball shape becomes stable when an oxidation resistant metal having a higher melting point than copper is used as the coating layer, and the elongation per unit cross sectional area of wire is 0.021%/µm² or greater. However, when a copper bonding wire having an elongation of 0.021%/µm² or greater is produced, there occurs the problem that the freedom of production process decreases for such reasons as limited annealing conditions. Accordingly, it is desired to provide a copper bonding wire that has excellent ball shape stability regardless of its elongation characteristic.

When the above-mentioned copper bonding wire is used, the reproducibility of the ball shape stabilizes and the bond reliability improves, but according to a further investigation conducted by the present inventors, it has been found that the copper bonding wire tends to incur the short tail or no-stick defects described hereinafter.

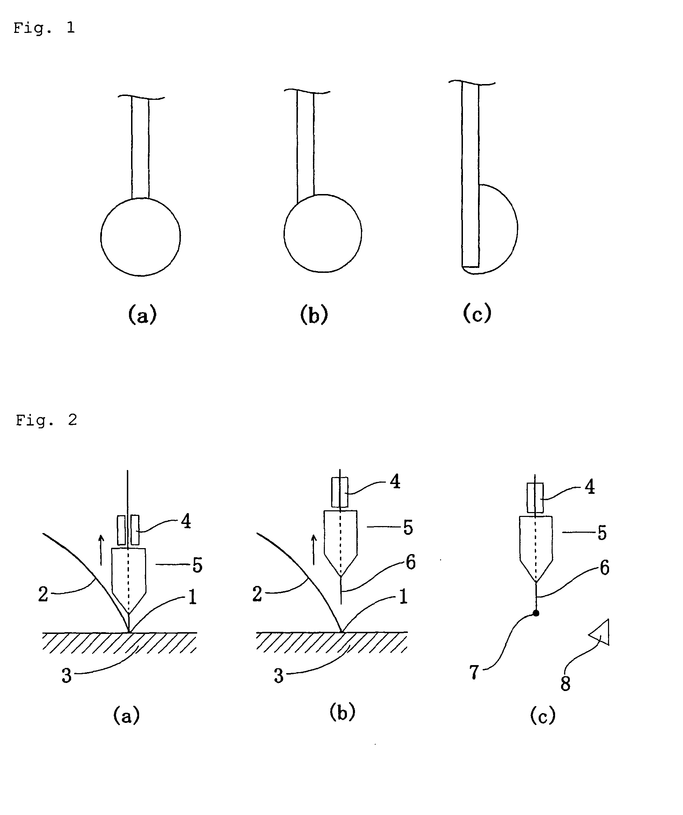

The short tail defect and the no-stick defect will be described with reference to Figures 1, 2, and 3.

Figure 2 is a schematic diagram showing the process from the second bonding to the formation of a ball for the next bond. As mentioned above, after the bonding wire 2 is connected to the wiring substrate 3 at the second bonding point 1 (Figure 2(a)), the bonding tool 5 is lifted up and the clamps 4 are closed; here, the bonding wire 2 is pulled by the clamps and is thus cut off at the second bonding point 1 (Figure 2(b)). Since the bonding tool 5 is being lifted up when the bonding wire 2 is cut, a prescribed length of bonding wire (tail 6) remains extending from the end of the bonding tool 5 after the cutting, and a new ball 7 for the next ball bond is formed at the end of the tail 6 by an electric discharge between it and the electrode torch 8 (Figure 2(c)).

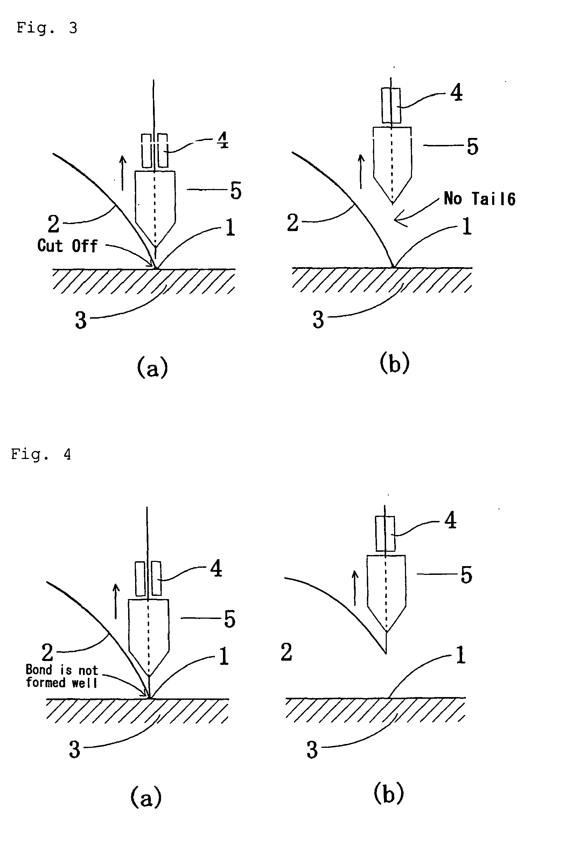

However, as shown in Figure 3, if the bonding wire 2 is cut off before the bonding tool 5 is lifted up to a prescribed height (Figure 3(a)), the tail 6 extending from the end of the bonding tool 5 becomes short, or no tail 6 is formed (Figure 3(b)), resulting in an inability to form the ball 7 for the next ball bond or in the formation of a ball smaller than the specified size. This defect is known as the short tail defect.

The no-stick defect is the defect in which a bond is not well formed during the second bonding and the connection comes off after the bonding, as shown in Figure 4.

As mentioned above, the connection between a bonding wire and a wiring substrate or the like is made by forming the bonds by applying pressure and ultrasonic energy simultaneously. To accomplish a good connection, the ultrasonic energy, pressing load, and the like must be controlled within a suitable range (good bonding condition range). However, if a bonding wire having a high defect rate is used, there arises the problem that the good bonding condition range is narrow, making condition control difficult when implementing the ball bonding method.

Further, in the case of a bonding wire having a high no-stick or short tail defect rate, even if the conditions are controlled within the good bonding condition range, the number of times the bonding can be performed in succession decreases because of the occurrence of such defects. Accordingly, it is desired to develop a copper bonding wire whose core is composed mainly of copper, and which does not easily incur no-stick or short tail defects.

For the production of a bonding wire whose core is coated with a coating layer of a metal having a higher melting point than the core material as previously described, preferably a method is employed in which a thick layer of metal is formed as a coating layer by electroplating or like method on a thick wire formed from the core material, the coated wire then being drawn a plurality of times to obtain the desired wire diameter and layer thickness. The combination of plating and wire drawing provides excellent results in terms of uniformity in thickness and smoothness of the surface; furthermore, since the method ensures good adhesion between the core material and the coating layer, this method can alleviate the problem of the bonding tool becoming clogged with flakes coming off the coating layer or the different metal layer.

However, a high melting point metal is generally difficult to draw, and it is pointed out that the method having the above-described excellent features still has the following problems 1 to 4, on which improvements are needed.
1. Compared with gold, the frequency of occurrence of wire breaks is high, and the yield is low.
2. Wire drawing dies easily wear, and the life of the dies is short.
3. While the possibility of coating layer delamination is reduced, there is still the possibility that the coating layer may partially flake off or cracking may occur in the coating layer during the wire drawing.
4. The diameter of the drawn wire may vary along the length thereof, or the cross-sectional shape of the drawn wire may deviate from the true round shape.

The problems 1 and 2 lead to increases in production cost, while the problems 3 and 4 cause degradation of bonding characteristics (Hereinafter, the problems 1 to 4 are called the "poor drawability problems").

### [DISCLOSURE OF THE INVENTION]

It is an object of the present invention to provide a bonding wire that comprises a core and a coating layer formed on the core and that has excellent ball shape stability, and in particular, a bonding wire wherein a displacement does not easily occur between the center of the wire and the center of the ball.

It is another object of the present invention to provide a bonding wire that comprises a core composed mainly of copper and a coating layer formed on the core, and that has excellent ball shape stability and does not easily incur a short tail defect, in particular, a no-stick defect.

It is a further object of the present invention to provide a bonding wire that comprises a coating layer formed on the core, the coating layer being made of a metal having a higher melting point than the core material, and that is free from the above-described poor drawability problems.

It is also an object of the present invention to provide an integrated circuit device that is produced by using such a bonding wire.

### [Means for Solving the Problems]

As a result of an investigation, the present inventor has found that if the wettability with the material of the coating layer (coating material) when the core material is melted is poor, that is, if the wet contact angle is large, the problem of the center of the ball becoming displaced from the center of the wire does not easily occur. That is, the inventor has found that a bonding wire having excellent ball shape stability can be obtained if the core material and the coating material that satisfy the following conditions 1) and 2) are used in combination, and has completed the present invention (first aspect) based on this finding.
1) The melting point of the coating material is higher than that of the core material.
2) The wet contact angle with the coating layer when the core material is melted is not smaller than 20 degrees.

As the first aspect of the present invention, there is provided a bonding wire comprising a core and a coating layer formed on the core, wherein the coating layer is formed from a metal having a higher melting point than the core, and the wet contact angle with the coating layer when the core is melted is not smaller than 20 degrees.

The wet contact angle with the coating layer when the core is melted refers to the contact angle when a lump of the core material mounted on the coating material is completely melted by heating to a temperature higher than the melting point of the core material. More specifically, it is the contact angle measured when the temperature was raised at a rate of 50°C/minute up to a point 40°C higher than the temperature at which the core material had begun to melt.

When this contact angle is 20 degrees or larger, the center of the ball is aligned with the center of the wire as shown in Figure 1(a), but when the angle is smaller than 20 degrees, the center of the ball tends to be displaced from the center of the wire as shown in Figure 2(b), resulting in a degradation of bond reliability.

In particular, when the contact angle is smaller than 10 degrees, the ball cannot maintain its spherical shape but is formed in such a shape as to rise along one side of the wire, as shown in Figure 1(c). On the other hand, when the contact angle is 30 degree or larger, a more favorable result can be obtained.

After investigating the correlation between every physical property of the wire and its effect on the short tail defect, the present inventor has found that the degree of curling of the bonding wire greatly affects the occurrence of the short tail defect, and that, when the degree of curling is a prescribed degree or smaller, (that is, curvature radius of the curling is the prescribed amount or larger), the possibility of occurrence of the short tail defect decreases to a level that does not cause a practical problem. Thus, the inventor has completed the present invention (second aspect) based on this finding. The prescribed degree of curling here refers to the curvature radius of the formed arc being 35 mm, when the bonding wire is hung down with its end touching a horizontal surface, and is cut at a point 15 cm above the end and thus let drop.

That is, as the second aspect of the present invention, there is provided a bonding wire comprising a core composed mainly of copper and a coating layer formed on the core, wherein the coating layer is formed from an oxidation resistant metal having a higher melting point than the core, and wherein when the bonding wire is hung down with its end touching a horizontal surface, and is cut at a point 15 cm above the end and thus let drop onto the horizontal surface, the curvature radius of the formed arc (hereinafter called the curvature radius) is 35 mm or larger. Specifically, the curvature radius is determined based on the curvature radius of the arc that is formed by a total of three points consisting of a midpoint of the length of wire thus let drop and points located 3 cm before and after the midpoint.

Presumably, the short tail defect occurs when the degree of curling of the wire is large, because then the friction between the wire and the inner surface of the bonding tool is large and the tension caused by the frictional force when the bonding tool is lifted up is applied to the wire which thus breaks. It is considered that since the copper bonding wire is more rigid than the gold bonding wire, the curling of the degree that would not cause a short tail defect in the gold bonding wire leads to a short tail defect in the case of the copper bonding wire because the friction is large as described above.

Therefore, it is desired to increase the curvature radius (the curvature radius) in order to reduce the short tail defect rate of the copper bonding wire. The curvature radius varies depending on the diameter of the guide roller over which the bonding wire passes, the tensile force applied to the wire, and the wire entrance/exit angles (the angles formed by the wire entering the roller and exiting the roller) during the production process of the bonding wire, and also on the diameter of the spool and the winding tension when the wire is shipped or stored. However, since the bonding wire passing over the guide roller is inevitably formed in a curled shape, it is not possible to obtain a bonding wire free from curling. Furthermore, if a bonding wire with reduced degree of curling (that is, increased curvature radius) is to be obtained, the diameter of the guide roller must be increased and/or the tensile force must be reduced, and it is therefore difficult to obtain a bonding wire with an extremely small degree of curling.

The present inventor has found that, as long as the curvature radius is made 35 mm or larger, the occurrence of the short tail defect can be prevented to a degree that does not become a problem in practice. There is, therefore, no need to increase the diameter of the guide roller or reduce the tensile force, attempting to increase the curvature radius to a value far larger than 35 mm; this facilitates the design of bonding wire production equipment as well as the selection of production conditions thereof.

More preferably, the curvature radius is 40 mm or larger.

Further, after investigating the correlation between every physical property of the wire and its effect on the no-stick and short tail defects, the present inventor has found that the yield strength of the bonding wire is closely related to the occurrence of the short tail defect and, in particular, to the occurrence of the no-stick defect, and that the frequency of occurrence of the no-stick defect can be reduced by setting the 0.2% yield strength to a value not greater than a prescribed value. The inventors have completed the present invention (third aspect) based on this finding.

That is, as the third aspect of the present invention, there is provided a bonding wire comprising a core composed mainly of copper and a coating layer formed on the core, wherein the coating layer is formed from an oxidation resistant metal having a higher melting point than the core, and wherein the 0.2% yield strength is not smaller than 0.115 mN/µm² but not greater than 0.165 mN/µm².

The bonding wire of the present invention is characterized in that the 0.2% yield strength is not smaller than 0.115 mN/µm² but not greater than 0.165 mN/µm². Here, the 0.2% yield strength refers to the stress that causes a 0.2% plastic deformation when a load is removed from a metallic material that does not exhibit a yield phenomenon. When the bonding wire whose 0.2% yield strength is not smaller than 0.115 mN/µm² but not greater than 0.165 mN/µm² is used, the frequency of occurrence of the no-stick defect as well as the short tail defect decreases, as a result of which the good bonding condition range can be extended, making condition management easy when implementing the ball bonding method.

A range not smaller than 0.125 mN/µm² but not greater than 0.155 mN/µm² is more preferable for the 0.2% yield strength of the bonding wire of the present invention.

More specifically, the value of 0.2% yield strength is calculated by dividing the stress at the intersection point of a stress curve and a line on a X-Y coordinates by the cross sectional area of the wire (*µ* m²) before drawing the wire, wherein the stress curve represents the relation between deformation (mm: X axis) and stress (Y axis) when a wire of 100 mm in length (length between chucks) is pulled at a rate of 1 mm/minute and the line passes the point of 0.2mm on the X axis and is parallel to the stress curve at the portion where stress is almost 0.

As a result of further investigation, the present inventor has also found that the wire drawability degrades if the hardness of the coating layer is high, and that the drawability can be improved (the poor drawability problems can be solved) by reducing the hardness of the coating layer to within a prescribed value, and has completed the present invention (fourth aspect) based on this finding.

That is, as the fourth aspect of the present invention, there is provided a bonding wire comprising a core and a coating layer formed on the core, wherein the coating layer is formed from a metal having a higher melting point than the core, and wherein the Vickers hardness of the coating layer is 300 or lower. When the Vickers hardness of the coating layer is held to within 300, excellent effects are achieved, for example, the wire drawability improves, and in particular, the frequency of occurrence of partial delamination or cracking of the coating layer during drawing decreases. More preferably, the Vickers hardness of the coating layer is 220 or lower; in this range, the wire drawability further improves.

When measuring the Vickers hardness, if the coating layer portion of the wire is directly measured for its hardness, there are cases where the measurement is difficult because of large errors for such reasons as the coating layer (plating layer) is thin, the wire surface is convex, and so on. In such cases, using the same plating solution and conditions as used for forming the coating layer, a plating layer should be formed to a suitable thickness on a plate made of the same material as the core material, and the Vickers hardness of this plating layer should be measured.

The present invention further provides any combination selected from the first to forth aspects mentioned above.

### Core material

For the bonding wire of the second aspect and the third aspect of present invention, the core material is composed mainly of copper. For the bonding wire of the first aspect and the forth aspect of present invention, the core material is not limited to any specific kind of material. Examples thereof include gold, silver, copper, etc. Copper bonding wire is preferable since it is less expensive than gold bonding wire, and it has suitable rigidity and is less prone to the problem of wires contacting and short circuiting due to resin flow during resin sealing. However, it has the problem that the short tail defect tends to occur more often than in the case of gold bonding wire. On the other hand, silver, which is less expensive than gold and is relatively soft, has the advantage that it gives less damage that may be caused to the bonding target during the bonding.

Here, the term "core composed mainly of copper or silver" includes a core consisting only of copper or silver. However, in the case of the core composed mainly of copper, it is preferable that other elements than copper are contained in a total amount not smaller than 0.001 weight percent but not larger than 1 weight percent relative to the weight of the core. When the amount of impurities is held within this range, good elongation characteristics can be obtained, and as a result, the ball shape stability improves.

Examples of other elements than copper to be contained in the core include beryllium, tin, zinc, zirconium, silver, chromium, iron, oxygen, sulfur and hydrogen. When elements other than copper are contained in an amount not smaller than 0.001 weight percent, not only the effect of achieving good elongation characteristics, but also the effect of being able to significantly reduce the possibility of wire breaking and the like. during processing can be obtained. However, an excessive amount of elements other than copper would not only have adverse effects on the electrical characteristics, such as increased electrical resistance, but also lead to the problems that craters are formed in the surface of the ball during the ball formation, and that the yield strength increases as will be described later. In view of this, it is desirable that the total amount of elements other than copper be held within 1 weight percent.

### Coating material

From the view point of preventing oxidation of the bonding wire, it is preferable to use an oxidation resistant metal for the coating material. Examples of such metals include gold, palladium, platinum and nickel.

Among others, an oxidation resistant metal having a higher melting point than the core material is preferable. This kind of metal differs depending on the kind of the core material. For example, when the core material is copper, it is preferable to form the coating layer from a metal whose melting point is at least 200°C higher than that of copper. When such a metal is used for the coating layer, the shape of the ball formed in the ball bonding process stabilizes, and formation of a spear-shaped ball can be prevented. Specific examples of metals whose melting point is at least 200°C higher than that of copper include palladium, platinum, and nickel, and a metal composed mainly of at least one element selected from the group consisting of palladium, platinum, and nickel is preferred for use. Of course, an alloy containing two or more elements selected from the group consisting of palladium, platinum, and nickel may be used for the coating layer, or alternatively, copper or other metal alloyed with a metal selected from the group consisting of palladium, platinum, and nickel may be used for the coating layer, provided that such an alloy is oxidation resistant and has a higher melting point than copper.

A metal composed mainly of at least one element selected from the group consisting of palladium, platinum, and nickel includes an alloy containing two or more elements selected from the group consisting of palladium, platinum, and nickel. Further, copper, silver, or other metal alloyed with a metal selected from the group consisting of palladium, platinum, and nickel may be used for the coating layer, provided that such an alloy is oxidation resistant and has a higher melting point than the core material and that the metal selected from the group consisting of palladium, platinum, and nickel is the main component of the alloy.

In the group consisting of palladium, platinum, and nickel, palladium is particularly preferable as it is relatively inexpensive, provides good plating adhesion, has better oxidation resistance than nickel, and has better workability (drawability) than platinum.

### Thickness of the coating layer

As for the thickness of the coating layer, the thickness that falls within the range satisfying as 0.007 ≦ Y ≦ 0.05 is preferable, where Y = (cross sectional area of coating layer / cross sectional area of core) in the cross section when the wire is cut vertically. When the thickness is within the thus defined range, the ball shape stability further improves, making it further easier to obtain a true spherical ball. More preferably, the range is 0.01 ≦ Y ≦ 0.04.

### Different metal layer

The bonding wire of the present invention comprises a core and a coating layer formed on the core; preferably, a different metal layer is provided between the core and the coating layer. Here, the different metal layer means a metal layer formed from a material different from any of the materials forming the core and the coating layer.

The different metal layer not only serves to prevent degradation of the plating solution used when forming the coating layer by plating, but also contributes to increasing the adhesion between the coating layer and the core. It also offers the effect of being able to easily maintain the ball in a true spherical shape over a wider range of ball diameters.

Examples of different metals usable as the material for the different metal layer include gold, platinum, palladium, rhenium, rhodium, ruthenium, titanium, magnesium, iron, aluminum, zirconium, chromium, nickel, silver, tin, zinc, osmium, iridium, and their alloys.

Among others, gold, platinum, palladium, chromium, nickel, silver, tin, zinc, and their alloys are preferable as the different metal layer can be easily formed by plating. Further, from the viewpoint of preventing degradation of the plating solution used for forming the coating layer, metals that have low ionization tendency and that can easily form a passivation layer are preferred for use; examples of such metals include gold, platinum, palladium, rhodium, ruthenium, titanium, iron, aluminum, zirconium, chromium, nickel, and their alloys. Of these preferred metals, gold, platinum, or palladium is particularly preferable.

The different metal may be a metal whose melting point is lower than that of the core material (copper). Further, the same metal may be used for both the different metal layer and the coating layer if they are formed using different plating methods. For example, the different metal layer is formed by strike electroplating while, on the other hand, the coating layer is formed by electroplating. That is, even when the metal layers are formed from the same metal, if they are formed using different plating methods, it follows that the metal layers are formed from different materials.

The thickness of the different metal layer is not specifically limited. Usually, the thickness is preferably 0.001 µm to 0.1 µm, and more preferably 0.001 µm to 0.03 µm. Usually, a thickness about 0.001 to 0.1 times that of the coating layer suffices for the purpose.

### Elongation per unit cross sectional area

The bonding wire of the present invention exhibits excellent ball shape stability irrespective of its elongation per unit cross sectional area, but in the case of the bonding wire whose core is composed mainly of copper, it is preferable that the elongation per unit cross sectional area is 0.021%/µm² or more, because the wire then exhibits further excellent ball shape stability. The elongation per unit cross sectional area is defined as the value obtained by dividing the wire elongation (percentage) achieved when a 10-cm long wire is pulled at a rate of 20 mm/minute until the wire breaks, by the cross sectional area of the wire before pulling (the sum [µm²] of the core and the coating layer, or if the different metal layer is provided, the sum [µm² of the core, the different metal layer, and the coating layer).

### Coating layer B

When a layer of a soft metal whose Vickers hardness is 150 or less is formed as the outmost layer of the bonding wire, the wire drawability further improves, and in particular, the life of the drawing die can be extended. It is therefore preferable to coat the coating layer with a soft metal whose Vickers hardness is 150 or less.

As the material for the coating layer B, a metal whose Vickers hardness is 100 or less is more preferable. Of such metals, gold which has excellent oxidation resistance and malleability is particularly preferable.

If the melting point of the coating layer B, i.e., the outermost layer, is lower than that of the coating layer, there can occur the problem that the ball tends to be formed in a spear-like shape. This problem, however, can be avoided by making the thickness of the coating layer B smaller than that of the coating layer and not larger than 0.002 times the wire diameter. More preferably, the thickness of the coating layer B is not larger than 0.001 times the wire diameter.

The bonding wire of the present invention may include a further layer in addition to the core, the coating layer, the different metal layer, and the coating layer B, as long as the additional layer does not harm the effect of the invention. The coating layer, the different metal layer, and the coating layer B may each be formed from multiple layers.

### Diameter of the bonding wire

The diameter of the bonding wire of the present invention is not specifically limited, but when an object is to form a small diameter ball, a wire diameter of 15 to 40 µm is preferable.

### Integrated circuit device

The present invention further provides an integrated circuit device produced by using the above-described bonding wire. The bonding wire of the present invention not only exhibits excellent ball shape stability, and the like but also has excellent drawability, and is advantageous in terms of production cost as well as bonding characteristics. Accordingly, using this bonding wire, electrodes on an integrated circuit device can be connected to a circuit wiring substrate in a stable manner, and the integrated circuit device produced by using the above-described bonding wire has stable quality and is advantageous in terms of production cost.

### Production method for the bonding wire

For the production of the bonding wire, a thick layer of metal plating is formed as the coating layer on a thick copper wire, and if the different metal layers and the coating layer B are also to be formed, thick layers of metals for forming these layers are also formed on the wire, and the thus coated wire is drawn a plurality of times to obtain the desired wire diameter and layer thickness. This method is economical and preferable. The combination of electroplating and wire drawing provides excellent results in terms of uniformity in thickness and smoothness of the surface. Furthermore, since the method ensures good adhesion between the core material, the different metal layer, and the coating layer, this method can solve the problem of the bonding tool becoming clogged with flakes coming off the coating layer or the different metal layer.

### Method for forming the coating layer

For the method for forming the coating layer on the core, an electroplating method is preferred for use. When also forming the different metal layer, a method is advantageously employed that forms the different metal layer on the core by electroplating or like method and then forms the coating layer thereon by electroplating. For the formation of the different metal layer, strike electroplating is particularly preferred for use. Other possible methods for forming thin films such as the different metal layer are chemical vapor deposition and physical vapor deposition.

Usually, after the final finished wire diameter has been obtained by drawing the wire, the bonding wire is subjected to annealing ("final annealing") to adjust its elongation. To obtain a bonding wire having elongation per unit cross sectional area of 0.21%/µm² or more, it is preferable to perform annealing partway through the drawing process after forming the coating layer, in addition to the final annealing.

In the bonding wire of the present invention that uses a core composed mainly of copper, since the curvature radius varies depending on the diameter of the guide roller over which the bonding wire passes, the tensile force applied to the wire, and the wire entrance/exit angles during the production process, the curvature radius that falls within the previously described preferred range can be easily obtained by suitably adjusting the diameter and the tensile force. Here, preferable values for the diameter of the guide roller and the tensile force applied to the wire vary depending on the diameter of the bonding wire, etc. Further, since the curvature radius also varies depending on the winding diameter of the spool or the like used when the wire is shipped or stored, the preferable values for the diameter of the guide roller and the tensile force applied to the wire also vary depending on the winding diameter of the spool or the like. However, the preferable values for the diameter of the guide roller and the tensile force applied to the wire can be easily obtained by preliminary experiments, or the like.

The yield strength of the bonding wire of the present invention that uses a core composed mainly of copper is dependent on the amount and kinds of the impurities contained in the copper material, the annealing temperature and annealing time at the time of wire production, and the work hardness at the time of wire drawing. Generally, the smaller the amount of impurities contained in the copper material, the smaller the value of the yield strength. Further, the value of the yield strength decreases as the annealing temperature and the annealing time increase. Accordingly, a bonding wire whose 0.2% yield strength is within the range of 0.115 to 0.165 mN/µm² can be obtained by adjusting the amount of the impurities contained in the copper material, the annealing temperature, the annealing time, etc.

Further, the value of the yield strength generally tends to decrease when annealing is performed a plurality of times before the final finished wire diameter is obtained. The wire is drawn into a smaller diameter wire by passing it through a drawing die having a bore diameter smaller than the wire diameter. Here, when the wire is drawn, while applying a suitable lubricating oil, through a die whose bore diameter is not much smaller than the wire diameter, a bonding wire having a small yield strength value can be obtained.

The method for forming the coating layer on the core includes an electroplating method. When also forming the coating layer B, the coating layer B is formed by electroplating or like method after forming the coating layer.

The hardness of the coating layer B and the hardness of the coating layer that fall within the previously described preferred hardness range are achieved by selecting the materials and the plating solution and plating conditions used. Even if the same metal is used, the hardness varies depending on the plating solution and plating conditions used, because the amount and kinds of impurities and the plating structure differ depending on them. For example, the Vickers hardness of palladium can be varied over a range of 200 to 460.

### [BRIEF DESCRIPTION OF THE DRAWINGS]

Figure 1 is a schematic diagram showing the condition of a ball formed on a bonding wire.
Figure 2 is a schematic diagram showing a processing step after second bonding.
Figure 3 is a schematic diagram showing a processing step after second bonding.
Figure 4 is a schematic diagram showing a processing step after second bonding.

### [Effect of the Invention]

When the ball bonding method is implemented using the bonding wire of the present invention that comprises a core and a coating layer formed on the core, and that is
characterized in that the coating layer is formed from a metal having a higher melting point than the core material and in that the wet contact angle with the coating layer when the core is melted is not smaller than 20 degrees, a true spherical ball is stably formed and the problem of the center of the ball becoming displaced from the center of the wire does not easily occur.

When the ball bonding method is implemented using the bonding wire of the present invention that comprises a core composed mainly of copper and a coating layer formed on the core, and that is characterized in that the coating layer is formed from an oxidation resistant metal having a higher melting point than the core and in that the curvature radius is 35 mm or larger, the shape of the formed ball is stable and the occurrence of the short-tail defect can be prevented, so that stable connections can be accomplished continuously.

When the bonding wire of the present invention is used that comprises a core composed mainly of copper and a coating layer formed on the core, and that is characterized in that the coating layer is formed from an oxidation resistant metal having a higher melting point than the core and in that the 0.2% yield strength is not smaller than 0.115 mN/µm² but not greater than 0.165 mN/µm², the frequency of occurrence of the no-stick defect as well as the short tail defect can be reduced, and stable connections can be accomplished continuously. Further, since the good bonding condition range is wide, it makes the condition control easy when implementing the ball bonding method.

Further, the bonding wire of the present invention characterized in that the Vickers hardness of the coating layer is 300 or less provides good drawability and can significantly alleviate the problems of the prior art such as: compared with gold, the frequency of occurrence of wire breaks during the wire drawing is high, and the yield is low; wire drawing dies easily wear, and the life of the dies is short; the coating layer may partially flake off or cracking may occur in the coating layer during the wire drawing; and the diameter of the drawn wire may vary along the length thereof or the cross-sectional shape of the drawn wire may deviate from the true round shape. In particular, in the case of the bonding wire provided with the coating layer B whose Vickers hardness is 150 or less as the outermost layer, the wear of the dies can be further reduced.

As described above, since stable connections between the electrodes on an integrated circuit device and the circuit wiring substrate can be accomplished using the bonding wire of the present invention described above, the bonding wire is used advantageously for the production of an integrated circuit device. The integrated circuit device produced by using this bonding wire has stable quality.

As the fifth aspect, the present invention also provides an integrated circuit device produced by using this bonding mentioned above.

### [Examples]

The present invention will be described in further detail below with reference to specific examples. It should be construed that the examples disclosed herein are by no means intended to restrict the scope of the present invention.

### Example 1

A coating was formed to a thickness of 0.8 µm by electroplating on a core copper wire having a purity of 99.995% and a diameter of 200 µm. By drawing and annealing this wire, various kinds of bonding wires were produced, each having a core diameter of 25.2 µm and a coating layer thickness of 0.1 µm. Using each wire, 100 balls of diameter 60 µm were formed by using a bonder (Model FB137 manufactured by Kaijo corporation), and the number of occurrences of a shape defect in which the center of the ball was displaced from the center of the wire was examined. The results are shown in Table 1 along with the core materials and coating materials used.

Wet contact angle at the time of core material melting was measured in the following manner by using high temperature wettability test equipment WET1200 manufactured by ULVAC-RIKO.

A lump of material produced by compressing a 2.5-mm size ball of core material into an easily mountable shape was placed on a sheet of coating material having a thickness of 1.5 mm and surface roughness Ra = 100 nm. The atmosphere was replaced by nitrogen with a purity of 99.9999% and was heated at a rate of 50°C/minute while flowing the nitrogen at a rate of 1L/minute. The wet angle was measured when the temperature reached a point 40°C higher than the temperature at which the lump had begun to melt. The measured values were corrected for the specific weights of the respective core metals (silver: 10.49, gold: 19.26, and copper: 8.93).

**Table 1**

| | Experiment | | | | |
|---|---|---|---|---|---|
| | 1 | 2 | 3 | 4 | 5 |
| Coating material (Melting point, °C) | Palladium (1554) | Nickel (1455) | Palladium (1554) | Palladium (1554) | Gold (1064) |
| Core material (Melting point, °C) | Copper (1084) | Copper (1084) | Silver (962) | Gold (1064) | Silver (962) |
| Wet contact angle | 40° | 35° | 24° | 26° | 6° |
| Defect rate | 0/100 | 1/100 | 15/100 | 20/100 | 100/100 |

As can be seen from the results shown in Table 1, the defect rate was low in the experiments 1 to 4 in which the wet contact angle was larger than 20 degrees but, in the experiment 5 in which the wet contact angle was smaller than 20 degrees, all of the 100 balls formed were defective.

### Example 2

(1) A film of gold strike plating was formed to a thickness of about 0.04 µm by strike electroplating on a copper wire having a purity of 99.995% and a diameter of 200 µm. After which a film of palladium plating was formed to a thickness of 0.8 µm. By drawing and annealing this wire, copper bonding wires were produced, each having a copper core diameter of 25.2 µm, a palladium layer (coating layer) thickness of 0.1 µm, a gold layer (different metal layer) thickness of about 0.005 µm, and an elongation of 15%. By adjusting the diameter of the guide roller and the tensile force used to wind the wire around a spool, samples with various curvature radiuses were produced. Using each sample, bonding was performed on a 208-pin QFP (copper lead frame, silver spot plating) with a loop length of about 4 mm by applying a load of 80g and ultrasonic energy of 160 by using a bonder (Model EAGLE AB339 manufactured by ASM), and the defect rate (ppm: the number of occurrences of short tail defect and no-stick defect, in total, per million bonds) was examined. The results are shown in Table 2. Continuous bondability was judged to be good, marked ○, when the defect rate was less than 500 ppm, and was judged to be bad, marked by X, when the defect rate was 500 ppm or higher. The results are shown in Table 2.
(2) Using the same samples as those used in (1), experiments were conducted by repeating the conditions used in (1), except that the ultrasonic energy was varied, and the ultrasonic energy range (good bonding condition range) within which the defect rate was less than 500 ppm was obtained. The results are shown in Table 2.

**Table 2**

| | Experiment | | | |
|---|---|---|---|---|
| | 1 | 2 | 3 | 4 |
| Curvature radius (mm) | 55 | 42 | 35 | 31 |
| Defect rate (ppm) | 10 | 14 | 360 | 2000 |
| Continuous bondability | ○ | ○ | ○ | × |
| Good bonding condition range | 80~190 | 80~190 | 80~160 | 90~140 |

As can be seen from the results shown in Table 2, in the experiment 4 in which the curvature radius was less than 35 mm, the defect rate was 2000 ppm, that is, a short tail defect or no-stick defect occurred for every 500 bonds, but in the case of the experiment 3 in which the curvature radius was only slightly larger than that in the experiment 4, the defect rate greatly improved to 360 ppm which means about one defect for every 3000 bonds; this defect rate does not become a problem in practice. The defect rate further improved in the experiments 1 and 2 in which the curvature radius was larger than 40 mm.

### Example 3

A film of gold strike plating was formed to a thickness of about 0.04 µm by strike electroplating on a copper wire having a purity of 99.995% and a diameter of 200 µm. After which a film of palladium plating was formed to a thickness of 0.8 µm. By drawing and annealing this wire, copper bonding wires with various yield strength values were produced, each having a copper core diameter of 25.2 µm, a palladium layer (coating layer) thickness of 0.1 µm, and a gold layer (different metal layer) thickness of about 0.005 µm. The curvature radius of each copper bonding wire was 40 mm. Using each wire, bonding was performed on a 208-pin QFP (copper lead frame, silver spot plating) with a loop length of about 4 mm by applying a load of 80g, while varying the ultrasonic energy, by using a bonder (Model EAGLE AB339 manufactured by ASM), and the ultrasonic energy range (good bonding condition range) within which the defect rate (ppm: the number of occurrences of short tail defect and no-stick defect, in total, per million bonds) was less than 200 ppm (one defect for every 5000 bonds) was examined. The results are shown in Table 3. The yield strength here is the average value of the values obtained at 10 points by pulling a 100-mm long sample at a rate of 1 mm/minute.

**Table 3**

| | Experiment | | | | | |
|---|---|---|---|---|---|---|
| | 1 | 2 | 3 | 4 | 5 | 6 |
| 0.2% yield strength (mN/µm²) | 0.109 | 0.123 | 0.128 | 0.153 | 0.160 | 0.178 |
| Good bonding condition range (Ultrasonic energy range) | 100-140 | 80-160 | 80-180 | 80-180 | 90-170 | 120-160 |

As can be seen from the results shown in Table 3, the good bonding condition range was extremely narrow in the experiment 6 in which the 0.2% yield strength was greater than 0.165 mN/µm² and also in the experiment 1 in which the 0.2% yield strength was less than 0.115 mN/µm². On the other hand, a particularly wide good bonding condition range was obtained in the experiments 3 and 4 in which the 0.2% yield strength was not less than 0.125 mN/µm² but not greater than 0.155 mN/µm².

### Example 4

### Experiments 1 - 3

A film of gold strike plating was formed to a thickness of about 0.04 µm by strike electroplating on a copper wire having a purity of 99.995% and a diameter of 200 µm. After which a film of plating of each metal was formed to a thickness of 0.8 µm by electroplating. By drawing this wire, bonding wires were produced, each having a copper core diameter of 25 µm, a gold strike plating layer (different metal layer) thickness of about 0.005 µm, and a metal plating layer (coating layer) thickness of 0.1 µm.

### Experiment 4

A film of gold strike plating was formed to a thickness of about 0.04 µm by strike electroplating on a copper wire having a purity of 99.995% and a diameter of 200 µm. After which a film of palladium plating was formed to a thickness of 0.8 µm by electroplating, and then, a film of gold was formed to a thickness of 0.16 µm by electroplating. By drawing this wire, a bonding wire was produced, having a copper core diameter of 25 µm, a gold strike plating layer (different metal layer) thickness of about 0.005 µm, a palladium plating layer (coating layer) thickness of 0.1 µm, and a gold plating layer (coating layer B = outmost layer) thickness of 0.02 µm.

### Experiment 5

By drawing a gold wire having a purity of 99.99% and a diameter of 200 µm, a bonding wire having a core diameter of 25 µm was produced.

### (Method of evaluation)

To evaluate wire drawability, (1) the life of the wire drawing die and (2) the presence or absence of cracking or delamination of the coating layer on the drawn wire along a 10-m length thereof were examined. If the drawing die wears during wire drawing, the surface of the wire wound on the reel begins to appear glaring because the surface roughness of the wire increases. The life of the drawing die in (1) was defined in terms of the length of the wire (final finished diameter) drawn until the glaring appeared.

**Table 4**

| | Experiment | | | | |
|---|---|---|---|---|---|
| | 1 | 2 | 3 | 4 | 5 |
| Core material | Copper | Copper | Copper | Copper | Gold |
| Coating material | Palladium | Palladium | Platinum | Palladium | None |
| Vickers hardness of coating layer | 210 | 400 | 650 | 210 | - |
| Material of coating layer B | None | None | None | Gold | None |
| Vickers hardness of coating layer B | - | - | - | 50 | - |
| (1) Life of drawing die | 200,000 m | 100,000 m | 50,000 m | 300,000 m | 600,000 m |
| (2) Presence or absence of cracking/delamination of coating layer | None | Certain amount of cracking/ delamination occurred | Cracking/ delamination | None | None |

In the experiments 2 and 3 in which a material having a Vickers hardness greater than 300 was used for the coating layer, cracking/delamination of the coating layer occurred, and the life of the drawing die was short. On the other hand, in the experiment 1 according to the present invention in which the Vickers hardness of the coating layer was 300 or less, cracking/delamination of the coating layer did not occur, and the life of the drawing die was long compared with the experiments 2 and 3. In particular, in the experiment 4 in which the palladium layer (coating layer) was covered with a gold coating layer B, cracking/delamination of the coating layer did not occur, and the life of the drawing die was longer than the above. The life long enough to suffice for most practical purposes was obtained, though it was shorter than in the case of the gold wire (experiment 5).

## Claims

1. A bonding wire comprising a core and a coating layer formed on the core, wherein the coating layer is formed from a metal having a higher melting point than the core, and the wet contact angle with the coating layer when the core is melted is not smaller than 20 degrees.

2. A bonding wire comprising a core composed mainly of copper and a coating layer formed on the core, wherein the coating layer is formed from an oxidation resistant metal having a higher melting point than the core, and wherein when the bonding wire is hung down with its end touching a horizontal surface, and is cut at a point 15 cm above the end and thus let drop onto the horizontal surface, the curvature radius of the formed arc is 35 mm or larger.

3. The bonding wire according to claim 2, wherein the curvature radius of the formed arc is 40 mm or larger.

4. A bonding wire comprising a core composed mainly of copper and a coating layer formed on the core, wherein the coating layer is formed from an oxidation resistant metal having a higher melting point than the core, and wherein the 0.2% yield strength is not smaller than 0.115 mN/µm² but not greater than 0.165 mN/µm².

5. The bonding wire according to claim 4, wherein the 0.2% yield strength is not smaller than 0.125 mN/µm² but not greater than 0.155 mN/µm².

6. A bonding wire comprising a core and a coating layer formed on the core, wherein the coating layer is formed from a metal having a higher melting point than the core, and wherein the Vickers hardness of the coating layer is 300 or lower.

7. The bonding wire according to claim 1 or 6, wherein the core material is composed mainly of copper.

8. The bonding wire according to any one of claims 2 - 5 and 7, wherein the coating layer is formed from a metal whose melting point is at least 200°C higher than that of copper.

9. The bonding wire according to any one of claims 2 - 5, 7 and 8, wherein the elongation per unit cross sectional area is 0.021%/µm² or more.

10. The bonding wire according to any one of claims 2 - 5 and 7 - 9, wherein the core contains other elements than copper in a total amount not smaller than 0.001 weight percent but not larger than 1 weight percent relative to the weight of the core.

11. The bonding wire according to claim 1 or 6, wherein the core material is composed mainly of silver.

12. The bonding wire according to claim 6, which has a coating layer B whose Vickers hardness is 150 or less, outside of the coating layer, as the utmost layer.

13. The bonding wire according to claim 12, wherein the material for the coating layer B is gold.

14. The bonding wire according to claim 12 or 13, wherein the thickness of the coating layer B is smaller than that of the coating layer and not larger than 0.002 times the wire diameter.

15. The bonding wire according to any one of claims 1 - 14, wherein the coating layer is formed from a metal composed mainly of at least one element selected from the group consisting of palladium, platinum, and nickel.

16. The bonding wire according to claim 15, wherein the coating layer is formed from palladium.

17. The bonding wire according to any one of claims 1 - 16, wherein the thickness of the coating layer falls within the range satisfying as 0.007 ≦ Y ≦ 0.05, where Y = (cross sectional area of coating layer / cross sectional area of core) in the cross section when the wire is cut vertically.

18. The bonding wire according to any one of claims 1 - 17, wherein a different metal layer is provided between the core and the coating layer.

19. An integrated circuit device that is produced by using the bonding wire according to any one of claims 1 - 18.
